# EUROPÄISCHE PATENTSCHRIFT

(11) **EP 0 556 902 B1**
(45) Veröffentlichungstag und Bekanntmachung des Hinweises auf die Patenterteilung: **14.05.1997**
(21) Anmeldenummer: 93200366.8
(22) Anmeldetag: 11.02.1993
(51) Int. Cl.: H03G 3/20

(54) **Schaltungsanordnung zur automatischen Verstärkungsregelung**
AGC circuit
Circuit pour commande automatique de gain

(30) Priorität: 19.02.1992 DE 4204956
(43) Veröffentlichungstag der Anmeldung: 25.08.1993
(73) Patentinhaber: Philips Patentverwaltung GmbH, 22335 Hamburg (DE); Philips Electronics N.V., 5621 BA Eindhoven (NL)
(72) Erfinder: Fischer, Jens, c/o Philips Patentverwaltung GmbH, W-2000 Hamburg 1 (DE); Jost, Jörg, c/o Philips Patentverwaltung GmbH, W-2000 Hamburg 1 (DE)
(74) Vertreter: von Laue, Hanns-Ulrich, Dipl.-Ing.

(56) Entgegenhaltungen:
- EP-A- 0 073 164
- US-A- 4 124 825
- US-A- 4 718 119

## Beschreibung

Die Erfindung betrifft ein Übertragungssystem versehen mit einem Empfänger mit einer Schaltungsanordnung zur automatischen Verstärkungsregelung nach dem Oberbegriff des Patentanspruchs 1. Weiterhin betrifft die Erfindung einen Empfänger und eine Schaltungsanordnung zur automatischen Verstärkungsregelung.

Bei der optischen Übertragung von seriellen Daten setzt eine auf der Empfangsseite eines Lichtwellenleiters angeordnete Photodiode von einem Sender erhaltene Lichtimpulse in ein elektrisches Datensignal um. Ein wechselspannungs-gekoppelter Vorverstärker verstärkt die kleinen Spannungspegel des umgesetzten Datensignals, um jene logischen Spannungspegel zu erzeugen, die integrierte Logikschaltungen für ihre Ansteuerungen benötigen. Durch die Wechselspannungskopplung des Vorverstärkers geht jedoch der Gleichspannungsanteil im Datensignal verloren. Der verlorengegangene Gleichspannungsanteil kann in einer Schaltung mit quantisierter Rückkopplung wieder zurückgewonnen werden. Bekannte Verstärkerschaltungen mit quantisierter Rückkopplung (IEEE Transactions on Magnetics, Vol. MAG. 14, No. 4, July 1978, Seiten 218 bis 222; ntz, Band 30 (1977), Heft 9, Seiten 712 bis 717) benötigen jedoch an ihrem Eingang ein Datensignal mit konstantem Spannungspegel. Der quantisierten Rückkopplungs-Schaltung ist daher eine Schaltungsanordnung zur automatischen Verstärkungsregelung vorzuschalten.

Aus der DE 25 00 654 B1 ist bereits eine Schaltungsanordnung zur Pegelregelung eines Datensignals bekannt. Dieses Datensignal ist Teil eines Signalgemisches, welches zusammen mit einem Pilotsignal über eine Übertragungsstrecke übertragen wird. Signale, die den Ist-Pegel und den Soll-Pegel des Pilotsignals signalisieren, werden dabei in einem Komparator miteinander verglichen und so eine Regelspannung abgeleitet, die einer Regelstufe zugeführt wird, mit der Pegel des Datensignals geregelt wird. Diese bekannte Schaltungsanordnung ist nicht geeignet, den Spannungspegel von Datensignalen konstant zu halten, die kein derartiges Pilotsignal enthalten.

Der vorliegenden Erfindung liegt die Aufgabe zugrunde, ein Übertragungssystem und einen Empfänger nach der eingangs genannten Art anzugeben, welches/welcher geeignet ist für Signale, insbesondere für NRZ-codierte Datensignale, bei welchen längere "0" - oder "1" -Folgen vorliegen.

Diese Aufgabe wird durch die im kennzeichnenden Teil die in den Patentansprüchen 1 und 5 angegebenen Merkmale gelöst.

Das erfindungsgemäße System bzw. der Empfänger mit den kennzeichnenden Merkmalen des Patentanspruchs 1 bzw. 5 hat den Vorteil, daß auch beim Vorliegen längerer "0"- oder "1" -Folgen in einem zu regelnden NRZ-Datensignal der Pegel konstant gehalten und damit in Verbindung mit einer guantisierten Rückkopplungs-Schaltung der verlorengegangene Gleichspannungsanteil im NRZ-Datensignal wieder hergestellt werden kann.

Durch die in den Unteransprüchen aufgeführten Maßnahmen sind vorteilhafte Weiterbildungen und Verbesserungen der in den Patentansprüchen 1 und 5 angegebenen Anordnung möglich.

Ein Ausführungsbeispiel der Erfindung ist in der Zeichnung dargestellt und in der nachfolgenden Beschreibung näher erläutert. Es zeigen:
- Fig. 1: ein System in dem die Erfindung verwendet werden kann,
- Fig. 2: eine erste Ausführungsform der Erfindung und
- Fig. 3: eine zweite Ausführungsform der Erfindung.

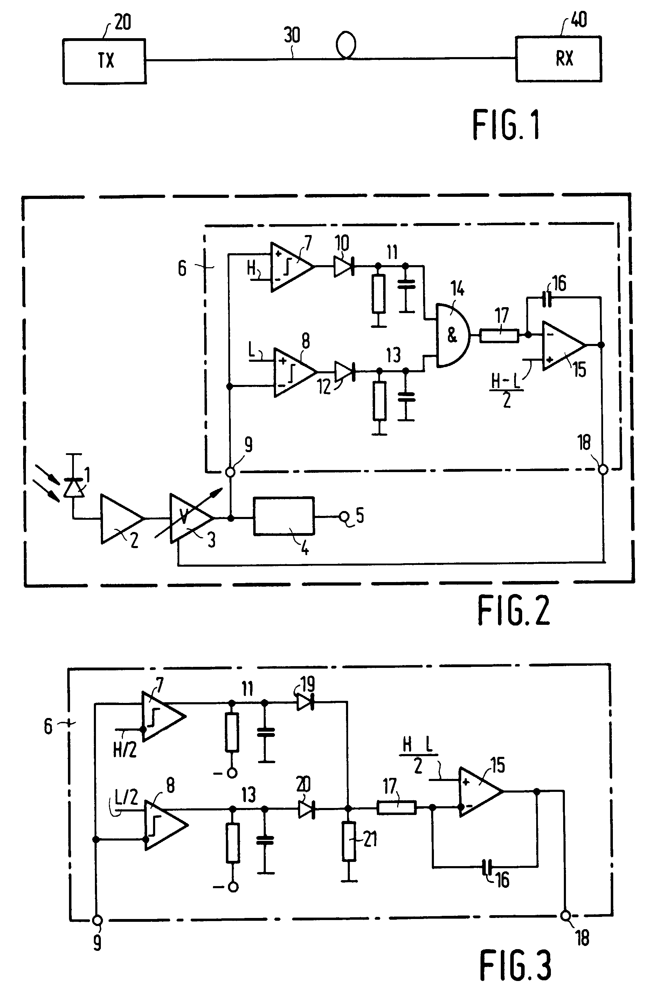

Die Fig. 1 zeigt ein Übertragungssystem mit einem Sender 20, der über einen Kanal 30 mit einem Empfänger 40 gekoppelt ist. Der Kanal 30 kann beispielsweise durch eine Glasfaser, einen Radarkanal oder eine Kabelverbindung gebildet werden. Auch kann der Kanal 30 durch ein magnetisches oder optisches Aufnahmesystem gebildet sein.

In der Figur 2 bezeichnet 1 eine Photodiode, die auf der Empfangsseite eines (nicht dargestellten) Lichtwellenleiters angeordnet ist, um von dem Lichtwellenleiter abgegebene Lichtimpulse wieder in ein elektrisches Datensignal umzuwandeln. Der Spannungspegel des am Ausgang der Photodiode 1 erhaltenen Datensignals beträgt nur wenige Millivolt. Es ist daher erforderlich, das von der Photodiode 1 abgegebene Datensignal zu verstärken, um nachgeschaltete integrierte Logikschaltkreise anzusteuern. Übliche gleichspannungs-gekoppelte Verstärker driften jedoch, so daß bei hohen Verstärkungsgraden das empfangene Datensignal begrenzt und damit nicht-linear verzerrt würde. Zur Vermeidung solcher Nachteile wird das von der Photodiode 1 abgegebene Datensignal von einem wechselspannungs-gekoppelten Vorverstärker 2 verstärkt, der jedoch den im Datensignal enthaltenen Gleichanteil unterdrückt, so daß das von dem wechselspannungs-gekoppelten Vorverstärker 2 verstärkte NRZ-Datensignal entsprechend der jeweils vorliegenden Bit-Folge um einen mittleren Gleichspannungspegel schwankt.

Zur Rückgewinnung des verlorengegangenen Gleichspannungsanteils im verstärkten Datensignal ist der Ausgang des wechselspannungsgekoppelten Vorverstärkers 2 mit dem Eingang eines Regelverstärkers 3 verbunden, dessen Ausgangssignal über eine quantisierte Rückkopplungsschaltung 4 geleitet wird, die ihrerseits an eine Klemme 5 ein gleichspannungs-behaftetes Datensignal abgibt. Wie eingangs erwähnt, benötigen derartige quantisierte Rückkopplungsschaltungen an ihrem Eingang einen konstanten Amplitudenpegel. Der zwischen dem wechselspannungsgekoppelten Vorverstärker 2 und der quantisierten Rückkopplungsschaltung 4 eingefügte Regelverstärker 3 sorgt für eine automatische Amplitudenregelung des vorverstärkten Datensignals. Dabei wird von dem am Ausgang des Regelverstärkers 3 liegenden Datensignal in einem Regelspannungsdetektor 6 eine Regelspannung abgeleitet, die über einen Regeleingang des Regelverstärkers 3 den Verstärkungsgrad und damit den Amplitudenpegel des von dem Regelverstärker 3 abgegebenen Datensignals beeinflußt.

Der strichpunktiert umrahmte Regelspannungsdetektor 6 umfaßt zwei Komparatoren 7 und 8, von denen der nicht-invertierende Eingang des Komparators 7 und der invertierende Eingang des Komparators 8 mit einer Eingangsklemme 9 verbunden sind. Der invertierende Eingang des Komparators 7 liegt auf einem logischen H-Pegel und der nicht-invertierende Eingang des Komparators 8 auf einem logischen L-Pegel. Überschreitet das an der Eingangsklemme liegende Datensignal den H-Pegel, so nimmt der Ausgang des Komparators 7 einem positiven Pegel an. In entsprechender Weise nimmt das Ausgangssignal des Komparators 8 einen positiven Pegel an, wenn das an der Eingangsklemme 9 liegende Datensignal den L-Pegel unterschreitet. Das Überschreiten des H-Pegels und das Unterschreiten des L-Pegels kann nie gleichzeitig auftreten. Ist das am Ausgang des Komparators 7 liegende Signal positiv, so wird es über eine Diode 10 zu einer RC-Kombination 11 geleitet und einer zeitlichen Mittelung unterworfen. In entsprechender Weise wird das am Ausgang des Komparators 8 liegende Signal bei positiven Pegeln über eine Diode 12 geführt und mit Hilfe einer RC-Kombination 13 gemittelt. Die beiden RC-Kombinationen 11 und 13 sind mit Eingängen eines UND-Gatters 14 verbunden. Der Ausgang des UND-Gatters 14 nimmt einen H-Pegel an, wenn ständig sowohl der H-Pegel als auch der L-Pegel des an der Eingangsklemme 9 liegenden Datensignals über- bzw. unterschritten wird. Der Ausgang des UND-Gatters 14 ist mit einem Integrator verbunden, der aus einem Operationsverstärker 15, einem in seinem Rückkopplungszweig befindlichen Kondensator 16 und einem in seiner Eingangszuleitung des invertierenden Eingang des Operationsverstärkers 15 liegenden Widerstand 17 besteht. Der nicht-invertierende Eingang des Operationsverstärkers 15 liegt auf einem (H-L)/2-Pegel. Die Beschaltung des Integrators 15 bis 17 ist so ausgelegt, daß bei H-Pegel am Ausgang des UND-Gatters 14 die am Ausgang (Ausgangsklemme 18) des Operationsverstärkers 15 abgegebenen Regelspannung verringert wird und damit die Verstärkung des Regelverstärkers 3 zurückgenommen und somit der Amplitudenpegel des Datensignals am Eingang der quantisierten Rückkopplungsschaltung 4 konstant gehalten wird.

Die Figur 3 zeigt eine weitere Ausgestaltung des in der Figur 2 dargestellten Regelspannungs-Detektors 6. Darin sind gleiche Teile mit gleichen Bezugszeichen versehen. Ebenso wie bei dem Regelspannungsdetektor 6 der Figur 2 wird auch bei dem Regelspannungsdetektor 6 der Figur 3 zunächst mit Komparatoren 7 und 8 ein Überschreiten oder Unterschreiten des an Klemme 9 liegenden Datensignals ermittelt, wobei jedoch nicht von H- oder L-Pegeln, sondern von H/2- bzw. L/2-Pegeln ausgegangen wird. Die RC-Kombination 11 ist direkt mit einem nicht-invertierenden Ausgang des Komparators 7 und die RC-Kombination 13 mit einem nicht-invertierenden Ausgang des Komparators 8 verbunden. Das in der Figur 1 dargestellte UND-Gatter 14 zur Verknüpfung der von den beiden Komparatoren 7 und 8 abgegebenen und anschließend gemittelten Signale ist in der Figur 2 diskret ausgeführt. Dabei ist eine in Durchlaßrichtung betriebene Diode 19 mit der RC-Kombination 11 und eine Diode 20 mit der RC-Kombination 13 verbunden. Den Arbeitspunkt der beiden Dioden 19 und 20 legt ein gegen Massepotential geschalteter Widerstand 21 fest.

In den Ausführungsbeispielen der Figur 2 und 3 wird das am Ausgang des UND-Gatters 14 bzw. 19 bis 21 zur Verfügung gestellte Signal in einer Integrierstufe 15 bis 17 integriert. Soll das Regelverhalten des Verstärkers 3 ein PI-Verhalten aufweisen, so kann dies in einfacher Weise dadurch erzielt werden, daß parallel zu dem Kondensator 16 ein Widerstand geschaltet wird. Auch ist es möglich, anstelle eines integrierenden Verstärkers einen Verstärker mit nichtintegrierendem Frequenzgang zu benutzen.

Die erfindungsgemäße Schaltungsanordnung zur automatischen Verstärkungsregelung wurde am Beispiel einer Anordnung zur Wiedergabe von optisch getragenen Datensignalen erläutert. Selbstverständlich ist es auch möglich, eine derartige Anordnung bei der Regenerierung von Datensignalen einzusetzen, die mit einem Magnetkopf von einem magnetischen Aufzeichnungsträger abgenommen werden; bei diesen Datensignalen ist aufgrund des Bandpaßcharakters des Kopf-Band-Kanals der Gleichspannungsanteil im Datensignal wieder herzustellen.

## Patentansprüche

1. Übertragungssystem mit einem Sender, welcher über einen Kanal mit einem Empfänger gekoppelt ist, welcher Empfänger versehen ist mit einer Schaltungsanordnung zur automatischen Verstärkungsregelung, enthaltend
- einen Regelverstärker mit einem Eingang zum Zuführen eines zu regelnden Signals, mit einem Ausgang zum Abgeben eines geregelten Ausgangssignals und mit einem Regeleingang zur Einstellung der Verstärkung in Abhängigkeit eines Regelsignals, und
- eine Anordnung zur Erzeugung des Regelsignals durch Gleichrichtung des von dem Regelverstärker abgegebenen Ausgangssignals,
**gekennzeichnet durch**
einen ersten Komparator (7) zur Abgabe eines ersten Signals, wenn das zu regelnde Signal einen bestimmten positiven Pegel überschreitet,
einen zweiten Komparator (8) zur Abgabe eines zweiten Signals, wenn das zu regelnde Signal einen bestimmten negativen Pegel unterschreitet,
einer Anordnung (10 bis 12) zur Mittelwertbildung des ersten und zweiten Signals und
eine Einrichtung (15 bis 17) zur Zusammenfügung der beiden gemittelten Signale, wenn sowohl der Mittelwert des ersten als auch der Mittelwert des zweiten Signals einen bestimmten Pegel überschreitet.

2. Übertragungssystem nach Anspruch 1, gekennzeichnet durch
eine erste Einrichtung (11) zur zeitlichen Mittelung des ersten Signals,
eine zweite Einrichtung (13) zur zeitlichen Mittelung des zweiten Signals,
eine Verknüpfungseinrichtung (14); 19 bis 21) zur logischen Verknüpfung der von der ersten und zweiten Einrichtung (11, 13) zur zeitlichen Mittelung erzeugten Signale und
eine Integrierstufe (15 bis 17), welche eingangsseitig mit einem Ausgang der Verknüpfungseinrichtung (14; 19 bis 21) und ausgangsseitig mit dem Regeleingang des Regelverstärkers (3) gekoppelt ist.

3. Übertragungssystem nach Anspruch 2, dadurch gekennzeichnet, daß die erste und zweite Einrichtung (11, 13) zur zeitlichen Mittelung des ersten und zweiten Signals jeweils aus einer RC-Kombination (11, 13) besteht.

4. Übertragungsystem nach Anspruch 2, dadurch gekennzeichnet, daß die Verknüpfungseinrichtung (14; 19 bis 21) zur logischen Verknüpfung der von der ersten und zweiten Einrichtung (11, 13) zur zeitlichen Mittelung erzeugten Signale ein UND-Gatter (14; 19 bis 21) ist.

5. Empfänger, versehen mit einer Schaltungsanordnung zur automatischen Verstärkungsregelung, enthaltend
- einen Regelverstärker mit einem Eingang zum Zuführen eines zu regelnden Signals, mit einem Ausgang zum Abgeben eines geregelten Ausgangssignals und mit einem Regeleingang zur Einstellung der Verstärkung in Abhängigkeit eines Regelsignals, und
- eine Anordnung zur Erzeugung des Regelsignals durch Gleichrichtung des von dem Regelverstärker abgegebenen Ausgangssignals,
**gekennzeichnet durch**
einen ersten Komparator (7) zur Abgabe eines ersten Signals, wenn das zu regelnde Signal einen bestimmten positiven Pegel überschreitet,
einen zweiten Komparator (8) zur Abgabe eines zweiten Signals, wenn das zu regelnde Signal einen bestimmten negativen Pegel unterschreitet,
einer Anordnung (10 bis 12) zur Mittelwertbildung des ersten und zweiten Signals und
eine Einrichtung (15 bis 17) zur Zusammenfügung der beiden gemittelten Signale, wenn sowohl der Mittelwert des ersten als auch der Mittelwert des zweiten Signals einen bestimmten Pegel überschreitet.

6. Empfänger nach Anspruch 5, gekennzeichnet durch
eine erste Einrichtung (11) zur zeitlichen Mittelung des ersten Signals,
eine zweite Einrichtung (13) zur zeitlichen Mittelung des zweiten Signals,
eine Verknüpfungseinrichtung (14); 19 bis 21) zur logischen Verknüpfung der von der ersten und zweiten Einrichtung (11, 13) zur zeitlichen Mittelung erzeugten Signale und
eine Integrierstufe (15 bis 17), welche eingangsseitig mit einem Ausgang der Verknüpfungseinrichtung (14; 19 bis 21) und ausgangsseitig mit dem Regeleingang des Regelverstärkers (3) gekoppelt ist.

7. Empfänger nach Anspruch 6, dadurch gekennzeichnet, daß die erste und zweite Einrichtung (11, 13) zur zeitlichen Mittelung des ersten und zweiten Signals jeweils aus einer RC-Kombination (11, 13) besteht.

8. Empfänger nach Anspruch 6, dadurch gekennzeichnet,
daß die Verknüpfungseinrichtung (14; 19 bis 21) zur logischen Verknüpfung der von der ersten und zweiten Einrichtung (11, 13) zur zeitlichen Mittelung erzeugten Signale ein UND-Gatter (14; 19 bis 21) ist.

## Claims

1. A transmission system comprising a transmitter, coupled to a receiver by a channel, which receiver comprises a circuit arrangement for automatic gain control, which arrangement includes:
- a controllable amplifier having an input for receiving a signal to be controlled, an output for presenting a controlled output signal and having a control input for adjusting the gain as a function of a control signal, and
- generator means for producing the control signal by rectifying the output signal produced by the controllable amplifier,
characterized by
- a first comparator (7) for presenting a first signal when the signal to be controlled exceeds a specific positive level,
- a second comparator (8) for presenting a second signal when the signal to be controlled falls below a specific negative level,
- an averaging circuit (10 to 12) for averaging the first and second signals, and
- a circuit (15 to 17) for combining the two averaged signals if both the average value of the first and the average value of the second signal exceed a specific level.

2. The transmission system as claimed in Claim 1, characterized by
- a first averaging circuit (11) for time-averaging the first signal,
- a second averaging circuit (13) for time-averaging the second signal,
- combining means (14; 19 to 21) for logically combining the signals produced by the first and second averaging circuits (11, 13) for time-averaging the generated signals and
- an integrator stage (15 to 17) which is coupled on the input side to an output of the combining means (14; 19 to 21) and, on the output side, to the control input of the controllable amplifier (3).

3. The transmission system as claimed in Claim 2, characterized in that the first and second averaging circuits (11, 13) for time-averaging the first and second signals are constituted each by an RC combination (11, 13).

4. The transmission system as claimed in Claim 2, characterized in that the combining means (14; 19 to 21) for logically combining the signals produced by the first and second time-averaging circuits (11, 13) is an AND gate (14; 19 to 21).

5. A receiver, comprising a circuit arrangement for automatic gain control, which arrangement includes:
- a controllable amplifier having an input for receiving a signal to be controlled, an output for presenting a controlled output signal and having a control input for adjusting the gain as a function of a control signal, and
- generator means for producing the control signal by rectifying the output signal produced by the controllable amplifier,
characterized by
- a first comparator (7) for presenting a first signal when the signal to be controlled exceeds a specific positive level,
- a second comparator (8) for presenting a second signal when the signal to be controlled falls below a specific negative level,
an averaging circuit (10 to 12) for averaging the first and second signals, and
- a circuit (15 to 17) for combining the two averaged signals if both the average value of the first and the average value of the second signal exceed a specific level.

6. The receiver as claimed in Claim 5,
characterized by
- a first averaging circuit (11) for time-averaging the first signal,
- a second averaging circuit (13) for time-averaging the second signal,
- combining means (14; 19 to 21) for logically combining the signals produced by the first and second averaging circuits (11, 13) for time-averaging the generated signals and
- an integrator stage (15 to 17) which is coupled on the input side to an output of the combining means (14; 19 to 21) and, on the output side, to the control input of the controllable amplifier (3).

7. The receiver as claimed in Claim 6, characterized in that the first and second averaging circuits (11, 13) for time-averaging the first and second signals are constituted each by an RC combination (11, 13).

8. The receiver as claimed in Claim 6, characterized in that the combining means (14; 19 to 21) for logically combining the signals produced by the first and second time-averaging circuits (11, 13) is an AND gate (14; 19 to 21).

## Revendications

1. Système de transmission avec un émetteur qui est relié par l'intermédiaire d'un canal à un récepteur, lequel récepteur est doté d'un circuit de commande automatique du gain contenant
- un amplificateur de réglage avec une entrée pour l'alimentation d'un signal à régler, avec une sortie pour délivrer un signal de sortie réglé et avec une entrée de réglage pour le réglage du gain en fonction d'un signal de réglage, et
- un dispositif pour la production du signal de réglage par redressement du signal de sortie émis par l'amplificateur de réglage,
caractérisé par
un premier comparateur (7) pour la délivrance d'un premier signal lorsque le signal à régler dépasse un niveau positif déterminé,
un deuxième comparateur (8) pour la délivrance d'un deuxième signal lorsque le signal à régler passe sous un niveau négatif déterminé,
un dispositif (10 à 12) pour le calcul d'une moyenne des premier et deuxième signaux, et
un dispositif (15 à 17) pour la synthèse des deux signaux moyens lorsque la moyenne du premier signal ainsi que la moyenne du deuxième signal dépassent un niveau déterminé.

2. Système de transmission selon la revendication 1, caractérisé par
un premier dispositif (11) en vue du calcul d'une moyenne temporelle du premier signal,
un deuxième dispositif (13) en vue du calcul d'une moyenne temporelle du deuxième signal,
un dispositif de liaison (14; 19 à 21) en vue de la liaison logique des signaux produits par les premier et deuxième dispositifs (11, 13) pour le calcul d'une moyenne temporelle, et
un étage d'intégration (15 à 17) qui est relié côté entrée à une sortie du dispositif de liaison (14; 19 à 21) et, côté sortie, à l'entrée de réglage de l'amplificateur de réglage (3).

3. Système de transmission selon la revendication 2, caractérisé en ce que les premier et deuxième dispositifs (11, 13) en vue du calcul de la moyenne temporelle des premier et deuxième signaux se composent respectivement d'une combinaison RC (11, 13).

4. Système de transmission selon la revendication 2, caractérisé en ce que le dispositif de liaison (14; 19 à 21) en vue de la liaison logique des signaux produits par les premier et deuxième dispositifs (11, 13) pour le calcul d'une moyenne temporelle est une grille ET (14; 19 à 21).

5. Récepteur doté d'un circuit en vue de la commande automatique du gain contenant :
- un amplificateur de réglage avec une entrée pour l'alimentation d'un signal à régler, avec une sortie pour la délivrance d'un signal de sortie réglé et avec une entrée de réglage en vue de la commande du gain en fonction d'un signal de réglage, et
- un dispositif en vue de la production du signal de réglage par redressement du signal de sortie délivré par l'amplificateur de réglage,
caractérisé par
un premier comparateur (7) en vue de la délivrance d'un premier signal lorsque le signal à régler dépasse un niveau positif déterminé,
un deuxième comparateur (8) en vue de la délivrance d'un deuxième signal lorsque le signal à régler passe sous un niveau négatif déterminé,
un dispositif (10 à 12) pour la formation d'une moyenne des premier et deuxième signaux, et
un dispositif (15 à 17) pour la synthèse des deux signaux dont la moyenne a été calculée lorsque tant la valeur moyenne du premier signal que la valeur moyenne du deuxième signal dépassent un niveau déterminé.

6. Récepteur selon la revendication 5,
caractérisé par
un premier dispositif (11) pour le calcul d'une moyenne temporelle du premier signal,
un deuxième dispositif (13) pour le calcul d'une moyenne temporelle du deuxième signal,
un dispositif de liaison (14; 19 à 21) pour la liaison logique des signaux produits par les premier et deuxième dispositifs (11, 13) en vue du calcul d'une moyenne temporelle, et
un étage d'intégration (15 à 17) qui est relié côté entrée à une sortie du dispositif de liaison (14; 19 à 21) et côté sortie à l'entrée de réglage de l'amplificateur de réglage (3).

7. Récepteur selon la revendication 6, caractérisé en ce que les premier et deuxième dispositifs (11, 13) en vue du calcul d'une moyenne temporelle des premier et deuxième signaux se composent respectivement d'une combinaison RC (11, 13).

8. Récepteur selon la revendication 6, caractérisé en ce que le dispositif de liaison (14; 19 à 21) en vue de la liaison logique des signaux produits par les premier et deuxième dispositifs (11, 13) pour le calcul d'une moyenne temporelle est une grille ET (14; 19 à 21).
